(19) **Europäisches Patentamt**
**European Patent Office**
**Office européen des brevets**

(11) **EP 1 132 966 A2**

(12) **EUROPÄISCHE PATENTANMELDUNG**

(43) Veröffentlichungstag:
**12.09.2001   Patentblatt 2001/37**

(51) Int Cl.⁷: $H01L\ 27/108$, $G11C\ 11/4097$

(21) Anmeldenummer: **01105390.7**

(22) Anmeldetag: **09.03.2001**

(84) Benannte Vertragsstaaten:
**AT BE CH CY DE DK ES FI FR GB GR IE IT LI LU
MC NL PT SE TR**
Benannte Erstreckungsstaaten:
**AL LT LV MK RO SI**

(30) Priorität: **10.03.2000  DE 10011672**

(71) Anmelder: **Infineon Technologies AG**
**81669 München (DE)**

(72) Erfinder:
• **Frey, Alexander**
  **81735 München (DE)**
• **Schlösser, Till, Dr.**
  **01109 Dresden (DE)**
• **Weber, Werner, Dr.**
  **80637 München (DE)**

(74) Vertreter: **Reinhard - Skuhra - Weise & Partner**
**Friedrichstrasse 31**
**80801 München (DE)**

(54)   **Bit- und Wortleitungsanordnung für DRAM-Speicher**

(57)   Es wird ein DRAM-Speicher (50) mit einer Anzahl von DRAM-Speicherzellen (51) beschrieben, wobei die Speicherzellen (51) jeweils einen Speicherkondensator (52) und einen Auswahltransistor (12) aufweisen, die im Bereich einer zumindest im wesentlichen rechteckigen Zellfläche (59) ausgebildet sind, wobei die Zellflächen (59) eine größere Ausdehnung in Längsrichtung (L) als in Breitenrichtung (B) aufweisen, und die über eine Wortleitung (56, 57) und eine Bitleitung (55) mit der Zellperipherie verdrahtet oder verdrahtbar sind. Die Wortleitungen (56, 57) und die Bitleitung (55) sind über die Speicherzellen (51) geführt und zumindest im wesentlichen senkrecht zueinander orientiert. Um bei zunehmender Miniaturisierung der DRAM-Speicher-Strukturen beim Übergang von sogenannten "folded" Bitleitungs-Architekturen zu sogenannten "open" Bitleitungs-Architekturen zu erreichen, daß das Bitleitungsraster und damit auch das Raster korrespondierender Schreib-Leseverstärker linear mit der Längsausdehnung (L) der Speicherzellen (51) skaliert, ist erfindungsgemäß vorgesehen, daß die Bitleitungen (55) nunmehr senkrecht zur Längsausdehnung (L) der Speicherzellen (51) in Richtung der Breitenausdehnung (B) der Speicherzellen (51) orientiert sind.

FIG 6

4.0 F für 8 F² Zelle
3.5 F für 7 F² Zelle
3.0 F für 6 F² Zelle

55 — Metall-BL
56 — Metall-BL
57 — Metall-WL
— Poly-WL
— Poly-Metall-WL
— Kontakte
54 — BL-Kontakt
53 — Poly-Gate
52 — Deep-Trench

**Beschreibung**

Die vorliegende Erfindung betrifft zunächst eine integrierte DRAM-Speicherzelle gemäß dem Oberbegriff von Patentanspruch 1. Weiterhin betrifft die Erfindung einen DRAM-Speicher.

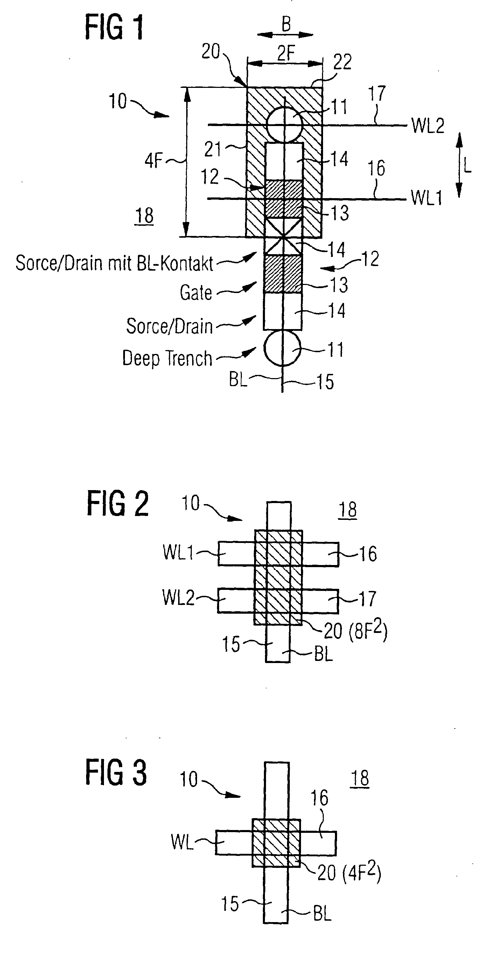

DRAM-Speicherzellen (Dynamic-Random-Access-Memory-Speicherzellen) und -speicher stellen einen wichtigen Speichertyp zum Speichern digitaler Informationen dar. Ein DRAM ist ein Speicher, bei dem man nach Vorgabe einer Adresse Daten abspeichern und unter dieser Adresse wieder auslesen kann. In DRAM-Speicherzellen, beziehungsweise -speichern, wird die Information nicht als Schaltzustand eines Schaltkreises, sondern als Ladungsmenge auf einer Kapazität gespeichert. Eine solche Speicherzelle kann somit mit nur einem Speicherkondensator und einem Auswahltransistor gebildet werden. Ein Beispiel für eine DRAM-Speicherzelle ist in Figur 1 dargestellt. Da jeder Kondensator Leckströme aufweist und auch über den Auswahltransistor Leckströme fließen, wird die Information in der DRAM-Speicherzelle kontinuierlich abgebaut. Der Informationsgehalt der Speicherzelle geht deshalb mit der Zeit verloren. Um dies zu vermeiden, werden die Inhalte der Speicherzellen periodisch ausgelesen, die Speicherinhalte bewertet und die Speicherzelle erneut beschrieben. Das bedeutet, daß die Ladungsinhalte der Speicherkondensatoren wieder aufgefrischt werden, was als "Refresh" bezeichnet wird.

DRAM-Speicherzellen sind üblicherweise zu Speicherzellenfeldern zusammengeschaltet, wobei ein DRAM-Speicher ein oder mehrere solcher Speicherzellenfelder aufweist. Zur Ausbildung der einzelnen Speicherzellenkomponenten (Speicherkondensator und Auswahltransistor) steht in der Regel nur eine begrenzte Fläche zur Verfügung, die Zellfläche genannt wird und eine im wesentlichen rechteckige Konfiguration aufweist. Die Zellfläche weist üblicherweise eine größere Ausdehnung in Längsrichtung (Längsausdehnung) als in Breitenrichtung (Breitenausdehnung) auf. Die einzelnen Komponenten der Speicherzelle beziehungsweise deren Einzelbestandteile sind innerhalb der Begrenzung der Zellfläche in der Regel in etwa in einer Linie und in einem bestimmten Abstand zueinander hintereinander angeordnet. Die dadurch begründete Ausdehnung der Speicherzelle und damit auch der Zellfläche wird als Längsausdehnung beziehungsweise Ausdehnung in Längsrichtung verstanden. Die senkrecht dazu begründete Ausdehnung der Speicherzelle und damit auch der Zellfläche wird als Breitenausdehnung beziehungsweise Ausdehnung in Breitenrichtung verstanden. Jede Speicherzelle ist über eine Wortleitung und eine Bitleitung mit der Zellperipherie verdrahtet oder verdrahtbar, wobei die Wortleitung und die Bitleitung über die Speicherzelle geführt und zumindest im wesentlichen senkrecht zueinander orientiert sind. Eine solche Ausgestaltung der Speicherzelle ist exemplarisch in Figur 1 dargestellt. Durch Aktivieren einer bestimmten Wortleitung lassen sich alle damit verbundenen Speicherzellen über ihre Bitleitungen auslesen, beschreiben oder bezüglich ihres Informationsgehalts auffrischen (refreshen).

Ein wesentliches Merkmal der DRAM-Entwicklung ist das Miniaturisieren der Strukturen. Zum einen wird die minimale, lithographisch zu erzeugende Strukturgröße F von Generation zu Generation ungefähr um den Faktor

$$\frac{1}{\sqrt{2}}$$

verkleinert. Andererseits wird die Architektur der Speicherzelle derart verändert, daß der Flächenverbrauch pro Bit sinkt.

Die Bitleitungsverdrahtung der einzelnen Zellen legt dabei ein Raster fest, in das ebenfalls Schreib-Leseverstärker eingeführt werden müssen. Schreib-Leseverstärker haben grundsätzlich die Aufgabe, aus den Bitleitungen ausgelesene Signale auszuwerten und zu verstärken.

Die benötigte Fläche für die gesamte Verdrahtung pro Speicherzelle definiert eine minimale Größe für die Zellfläche, bis zu der eine Speicherzellen-Architekturverkleinerung zu einer Flächeneinsparung führt. Würde diese minimale Zellgröße unterschritten, wäre der Platzbedarf einer solchen Verschaltung durch das Verdrahtungsraster festgelegt und damit unabhängig von der realisierten oder realisierbaren Zellgröße.

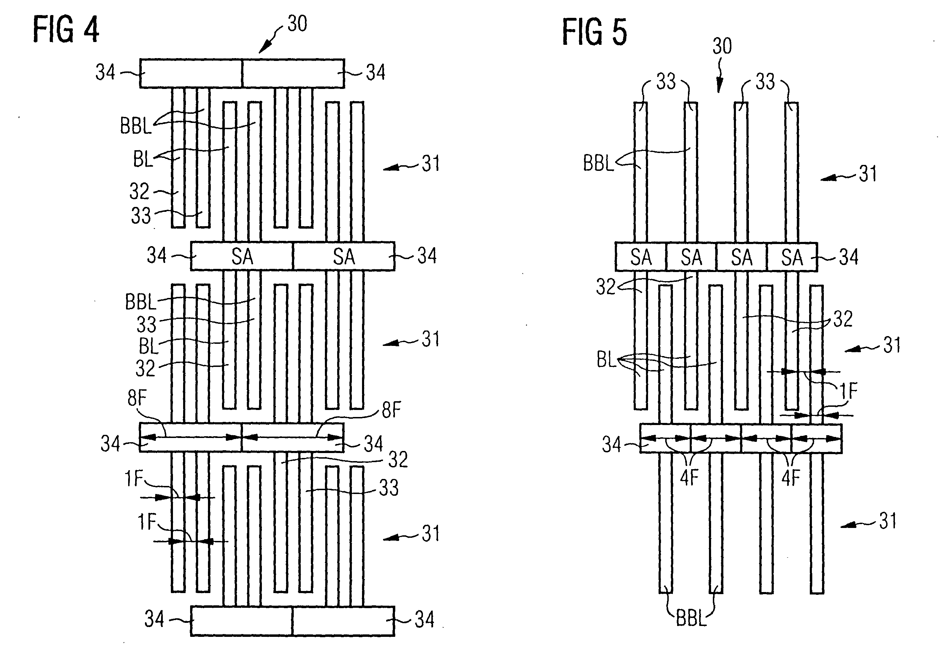

Bei der bisher verwendeten sogenannten "folded" Bitline-Architektur, wie sie beispielsweise in Figur 4 dargestellt und im Rahmen der Figurenbeschreibung näher erläutert wird, beträgt die pro Zelle für die Verdrahtung benötigte minimale Fläche 8 $F^2$. Dies ist beispielsweise auch aus Figur 2 ersichtlich. Im "folded" Bitleitungs-Konzept sind die einzelnen Bitleitungen jeweils nebeneinander angeordnet. Dabei sind jeweils zwei Bitleitungen erforderlich, nämlich eine zu bewertende Bitleitung BL sowie eine Referenz-Bitleitung BBL. Die Referenz-Bitleitung BBL hat die Aufgabe, ein aus der zu bewertenden Bitleitung, beziehungsweise Speicherzelle, ausgelesenes Signal mit einem Referenzwert zu vergleichen. Dies soll an Hand eines kurzen Beispiels erläutert werden.

In den DRAM-Speicherzellen können digitale Informationen beispielsweise in Form von logisch "0" und "1" gespeichert sein. Jeder dieser logischen Informationen ist ein bestimmter Spannungswert zugeordnet. Beispielsweise kann der Spannungswert für logisch "0" null Volt betragen, während der Spannungswert für logisch "1" beispielsweise 2 Volt beträgt. Vor dem Auslesen der Speicherzelle werden alle Bitleitungen mit einer Referenzspannung beaufschlagt, beispielsweise einer Spannung von 1 Volt. Beim Auslesen der Speicherzelle wird sich der Spannungswert je nach Informationsgehalt der Speicherzelle entweder etwas vergrößern, oder aber verkleinern. Dieser Spannungsänderung wird mit der in der Referenz-Bitleitung weiterhin vorherrschenden Referenzspannung von 1 Volt verglichen. Ist der Spannungswert in der zu bewertenden Bitleitung höher als der Referenzspannungswert, war die Speicherzelle mit dem Informationsgehalt logisch "1" beschrieben. Bei kleineren Spannungswerten war die Speicherzelle mit der Information logisch "0" beschrieben. Das aus der zu bewertenden Bitleitung sowie der Referenz-Bitleitung ausgelesene Spannungssignal wird in dem Schreib-Leseverstärker aufbereitet und weiterverarbeitet, beispielsweise verstärkt.

Im "folded" Bitleitungs-Konzept sind über jede Speicherzelle zwei Wortleitungen WL geführt. Eine Wortleitung aktiviert die ausgewählte Zelle, während sie die Nachbarzellen und damit die Nachbar-Bitleitung deaktiviert beläßt. Die zweite Wortleitung passiert lediglich die auszulesende Zelle und aktiviert, wenn ausgewählt, die Nachbarzellen. Eine Verdrahtungsarchitektur mit einer Bitleitung BL und zwei über die Speicherzelle parallel geführten Wortleitungen WL benötigt mindestens eine Fläche von 8 $F^2$, wie in Figur 2 dargestellt ist. Deshalb ist das "folded" Bitleitungs-Konzept nur für Zellen $\geq$ 8 $F^2$ sinnvoll.

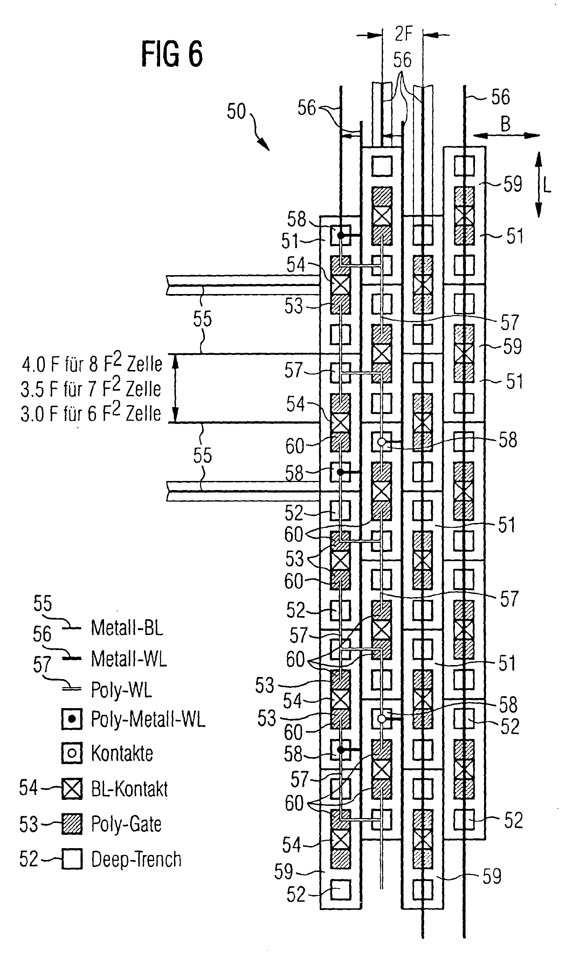

Die Architektur der DRAM-Speicherzelle erfordert ab der 4 Gbit Generation einen Flächenverbrauch unter 8 $F^2$. Die Verdrahtung muß dann so verändert werden, daß sie nicht den Platzbedarf des Zellenfeldes bestimmt. Erreicht wird dies, indem über jede Zelle nur eine einzige Wortleitung geführt wird. Dies ist beispielsweise in Figur 3 dargestellt. Wie aus dieser Figur ersichtlich ist, sinkt der minimale Platzbedarf für die Verdrahtung auf 4 $F^2$. Als Konsequenz für die Bitleitungs-Architektur ergibt sich der Übergang vom "folded" zum sogenannten "open" Bitleitungs-Konzept. Ein solches "open" Konzept ist beispielsweise in Figur 5 dargestellt und wird im Rahmen der Figurenbeschreibung näher erläutert. Wie aus Figur 5 ersichtlich ist, verringert sich das Raster der Schreib-Leseverstärker SA bei konventioneller Wortleitungs- und Bitleitungsanordnung von 8 F auf 4 F, und zwar unabhängig von der Größe der Speicherzelle. Dabei tritt die Verkleinerung des Rasters sprunghaft auf, was bedeutet, daß dieses Raster für jede Zelle erforderlich ist, die < 8 $F^2$ ist, ganz gleich, ob es sich dabei um eine 7 $F^2$, 6 $F^2$, 4 $F^2$ -Zelle oder dergleichen handelt.

Das Raster der Schreib-Leseverstärker (SA-Raster) wird, wie aus den Figuren 4 und 5 ersichtlich, unter anderem bestimmt von der Breite der Bitleitung BL, dem Abstand zwischen den Bitleitungen sowie von der Anordnung von Bitleitung BL und Referenz-Bitleitung BBL.

Für Zellen < 8 $F^2$ kann pro Zelle nur eine einzige Wortleitung WL zugeführt werden. Als Konsequenz hieraus werden die Nachbarzellen mitausgelesen und die Nachbar-Bitleitung kann nicht als Referenz-Bitleitung verwendet werden, wie dies bei dem in Figur 4 dargestellten "folded" Bitleitungs-Konzept möglich war. Statt dessen wird als Referenz-Bitleitung eine Bitleitung BBL aus einem Nachbarzellenfeld verwendet. Dadurch gelangt man zum "open" Bitleitungs-Konzept und das SA-Raster verringert sich sprunghaft von 8 F auf 4 F unabhängig von der Zellgröße.

Der Abstand zwischen benachbarten Bitleitungen ergibt sich in konventionellen Bitleitungs-Architekturen aus der Orientierung der Bitleitung in Richtung der Längsausdehnung der Zelle, wie dies beispielsweise aus Figur 1 ersichtlich ist. Der Abstand zweier benachbarter Bitleitungen ist damit durch die Breite der Speicherzelle festgelegt. Die Breite der Speicherzelle wiederum entspricht dem minimal möglichen Wert von 2 F, der sich durch 1 F Strukturbreite der Speicherzellenbauelemente sowie 1 F Abstand zu den benachbarten Speicherzellen ergibt.

Auf dem Weg zu den sogenannten "Trench-Zellen" mit Architekturen < 8 $F^2$ wird der Abstand zwischen Deep Trench und Gate verringert. Bei einem Deep-Trench-Kondensator handelt es sich um einen Zylinderkondensator, der in einer integrierten Schaltung senkrecht zur Oberfläche des Substrats ausgerichtet ist. Bei dem Gate handelt es sich beispielsweise um das Gate des Auswahltransistors. Wenn der Abstand zwischen dem Speicherkondensator und dem Gate verringert wird, wird die Speicherzelle dementsprechend in Längsrichtung verkleinert, was beispielsweise aus Figur 1 ersichtlich wird. Da die Bitleitung in Längsrichtung der Speicherzelle ausgerichtet beziehungsweise orientiert ist, bleibt der Bitleitungsabstand zwischen benachbarten Bitleitungen deshalb unabhängig von einer Zellverkleinerung konstant.

Insbesondere bei den "open" Bitleitungs-Architekturen ist die sprunghafte Reduzierung des Bitleitungsrasters und damit des Schreib-Leseverstärker-Rasters von 8 F auf 4 F problematisch. Der Grund hierfür liegt unter anderem darin, daß eine Auslegung des Schreib-Leseverstärkers in dem auf die Hälfte reduzierten Raster mit planaren Transistoren, aus denen dieser aufgebaut ist, sehr schwierig ist.

Aufgabe der vorliegenden Erfindung ist es daher, eine DRAM-Speicherzelle sowie einen DRAM-Speicher mit einer entsprechenden DRAM-Speicherzellenverdrahtung bereitzustellen, bei der/dem die beschriebenen Nachteile vermieden werden. Insbesondere soll es ermöglicht werden, Speicherstrukturen im Übergang vom "folded" zum "open" Konzept miniaturisieren zu können, ohne daß das Raster der Schreib-Leseverstärker in der wie oben beschriebenen Weise schlagartig um ein erhebliches Maß reduziert wird.

Diese Aufgabe wird gemäß dem ersten Aspekt der vorliegenden Erfindung gelöst durch eine integrierte DRAM-Speicherzelle, mit einem Speicherkondensator und einem Auswahlkondensator, die im Bereich einer zumindest im wesentlichen rechteckigen Zellfläche ausgebildet sind, wobei die Zellfläche eine größere Ausdehnung in Längsrichtung als in Breitenrichtung aufweist, und die über eine Wortleitung und eine Bitleitung mit der Zellperipherie verdrahtet oder verdrahtbar ist, wobei die Wortleitung und die Bitleitung über die Speicherzelle geführt und zumindest im wesentlichen senkrecht zueinander orientiert sind. Die DRAM-Speicherzelle ist erfindungsgemäß dadurch gekennzeichnet, daß die Bitleitung senkrecht zur Längsausdehnung der Speicherzelle in Richtung der Breitenausdehnung der Speicherzelle orientiert ist.

Auf diese Weise wird eine Bitleitungs-Architektur geschaffen, mit der ein entspanntes Schreib-Leseverstärker-Raster für DRAM-Speicherzellen < 8 F$^2$ erzielt werden kann.

Die grundsätzliche Idee zur Lösung des weiter oben beschriebenen Problems (die drastische, sprunghafte Reduktion des Schreib-Leseverstärker-Rasters von 8 F auf 4 F beim Übergang vom "folded" zum "open" Bitleitungs-Konzept) besteht in der Anordnung der Bitleitung senkrecht zur Längsrichtung der Zelle. Das beim Zusammenfügen einzelner DRAM-Speicherzellen zu einem DRAM-Speicher entstehende Bitleitungsraster, und damit auch das Schreib-Leseverstärker-Raster, wird nunmehr zu einer Funktion der Längsausdehnung der Speicherzelle. Dies wird im Hinblick auf den erfindungsgemäßen DRAM-Speicher weiter unten näher erläutert. Zu den Vorteilen, Wirkungen, Effekten sowie der Funktionsweise der erfindungsgemäßen DRAM-Speicherzelle wird deshalb auch auf die nachstehenden Ausführungen zum erfindungsgemäßen DRAM-Speicher vollinhaltlich Bezug genommen und hiermit verwiesen. Das Schreib-Leseverstärker-Raster skaliert nunmehr linear mit der Längsausdehnung der Speicherzelle. Dadurch kann das bisher bestehende und oben beschriebene Layout-Problem der Schreib-Leseverstärker reduziert werden.

Vorteilhaft Ausführungsformen der erfindungsgemäßen DRAM-Speicherzelle ergeben sich aus den Unteransprüchen.

Vorteilhaft kann die DRAM-Speicherzelle eine Zellfläche von < 8 F$^2$ aufweisen. Vorzugsweise können mittels der vorliegenden Erfindung 7 F$^2$ Zellen, 6 F$^2$ Zellen und dergleichen realisiert werden.

Vorteilhaft kann/können die Bitleitung und/oder die Wortleitung eine Breite von 1 F aufweisen.

Die Breite der Speicherzelle beträgt vorzugsweise 2 F, während die Speicherzelle vorzugsweise eine Zellenlänge von < 4 F aufweist.

Gemäß dem zweiten Aspekt der vorliegenden Erfindung wird ein DRAM-Speicher bereitgestellt, der eine Anzahl von wie vorstehend beschriebenen erfindungsgemäßen DRAM-Speicherzellen aufweist. Die Speicherzellen bilden jeweils ein oder mehrere Speicherzellenfelder, wobei jeweils mehrere Speicherzellen eines Speicherzellenfeldes mit einer -gemeinsamen- Wortleitung und einer -gemeinsamen- Bitleitung verbunden sind, wobei die Wortleitungen ein Wortleitungsraster und die Bitleitungen ein Bitleitungsraster bilden.

Zu den Vorteilen, Wirkungen, Effekten sowie der Funktionsweise des erfindungsgemäßen DRAM-Speichers wird ebenfalls auf die vorstehenden Ausführungen zur erfindungsgemäßen DRAM-Speicherzelle vollinhaltlich Bezug genommen und hiermit verweisen.

Die einzelnen Bitleitungen einer jeden Zelle sind nunmehr senkrecht zur Längsausrichtung der Speicherzelle, das heißt senkrecht zu deren Längsausdehnung und parallel zu deren Breitenausdehnung orientiert. Wenn nun die Speicherzellen in ihrer Länge verkürzt werden, etwa indem der Abstand zwischen den Gates der Auswahltransistoren und den Speicherkondensatoren verringert wird, macht sich diese Abstandsverringerung auch auf den Abstand zwischen benachbarten Bitleitungen bemerkbar, so daß diese im Maße der Verkürzung der Speicherzelle näher aneinander rücken. Dabei ist der Grad der Abstandsabnahme jedoch fließend und nicht sprunghaft wie bei dem im Rahmen der Beschreibungseinleitung erläuterten Übergang von der konventionellen "folded" zur konventionellen "open" Bitleitungs-Architektur.

Vorteilhafte Ausführungsformen des erfindungsgemäßen DRAM-Speichers ergeben sich aus den Unteransprüchen.

Vorteilhaft kann der DRAM-Speicher eine "open" Struktur aufweisen. Eine solche Struktur trägt in der oben beschriebenen Weise der fortschreitenden Miniaturisierung der DRAM-Speicher Rechnung.

Dabei kann als Referenz-Bitleitung für die auszulesende Bitleitung einer Speicherzelle eine Bitleitung aus einem anderen Speicherzellenfeld verwendet werden.

In vorteilhafter Weise wird das Bitleitungsraster als Funktion der Längsausdehnung der Speicherzellen gebildet. Dies weist die vorgenannten Vorteile auf.

Neben den zuvor beschriebenen Komponenten weist der DRAM-Speicher in der Regel einen oder mehrere Schreib-Leseverstärker auf, der/die zur Auswertung und Weiterverarbeitung der über die Bitleitungen übertragenen Signale mit diesen verdrahtet ist/sind. Ein Schreib-Leseverstärker hat die Aufgabe, die über die Bitleitungen laufenden Signale, die üblicherweise nur sehr kleine Signalwerte aufweisen, für weitere Verwendungsschritte auf die jeweils erforderlichen Signalwerte zu verstärken.

Vorzugsweise sind die Schreib-Leseverstärker in einem zum Bitleitungsraster korrespondierenden Raster angeordnet, so daß das Raster der Schreib-Leseverstärker linear mit der Längsausdehnung der Speicherzellen skaliert. Dies wird beispielsweise durch die nachstehende Formel verdeutlicht, die lautet:

$$\text{SA - Raster} = 2 \cdot \text{BL - Raster} = 2 \cdot \left(\frac{\text{Zellgröße}}{2F}\right) = \frac{\text{Zellgröße}}{F}$$

mit SA-Raster = Schreib-Leseverstärker-Raster, BL-Raster = Bitleitungsraster und F = der minimalen lithographischen Strukturgröße.

Vorzugsweise können jeweils mehrere Gates, insbesondere vier Gates, benachbarter Speicherzellen inselartig über eine Wortleitung miteinander verbunden sein.

Auf diese Weise läßt sich eine besonders vorteilhafte Anordnung der Wortleitungen, die in ihrer Gesamtheit ein Wortleitungsraster bilden, senkrecht zu den Bitleitungen, beziehungsweise dem Bitleitungsraster, realisieren. Bei den Gates handelt es sich beispielsweise um Gates der in jeder Speicherzelle vorgesehenen Auswahltransistoren.

Vorteilhaft kann diese Wortleitung als Polysiliziumleitung ausgebildet sein.

Diese Wortleitungen, die jeweils benachbarte Speicherzellen inselartig miteinander verbinden, sind wiederum in bestimmten Abständen mit einer weiteren Metall-Wortleitung verbunden, so daß die einzelnen Inseln, insbesondere die Polysilizium-Inseln, in den einzelnen Speicherzellen über die Metall-Wortleitungen miteinander verbunden sind.

Vorzugsweise sind die beiden Wortleitungen im DRAM-Speicher übereinander angeordnet.

Um zu gewährleisten, daß auf jede Bitleitung jeweils nur eine Speicherzelle ausgelesen wird, können zwei nebeneinander laufende Metall-Wortleitungen wechselseitig jeweils Speicherzellen-Gates verschiedenen Typs kontaktieren. Ein Beispiel hierfür ist im Hinblick auf Figur 6 dargestellt.

Zur Realisierung der Inseln müssen die, benachbarte Speicherzellen inselartig verbindende, Wortleitungen über das jeweilige Source-Drain-Gebiet der Speicherzelle(n) geführt werden, das den Speicherkondensator, beispielsweise den Deep-Trench-Kondensator, mit dem Auswahltransistor verbindet.

Nachfolgend wird hierfür eine mögliche Herstellungsvariante beschrieben. Die bei der Überführung der Wortleitungen über die Source-Drain-Gebiete erforderliche Isolation kann beispielsweise über einen sogenannten STI-Prozeß realisiert werden, wobei jedoch eine zusätzliche Fotoebene erforderlich ist. Bei dem STI-Verfahren (Shallow Trench Isolation) handelt es sich um eine Grabenisolation, bei der benachbarte Transistoren oder andere aktive Gebiete einer integrierten Schaltung durch Gräben seitlich isoliert werden, wobei die Gräben ins monokristalline Silizium geätzt und mit isolierendem Material aufgefüllt werden.

Zur Herstellung der vorstehend genannten Struktur kann beispielsweise zunächst das Gate des Auswahltransistors hergestellt werden, beispielsweise über eine geeignete Gate-Oxid- und Gate-Poly- und Gate-Nitrid-Abscheidung. Anschließend wird das Gate strukturiert. Danach erfolgt die STI-Ätzung sowie das sich daran anschließende Auffüllen der geätzten Bereiche mit Oxid. Dann kann die Struktur durch ein geeignetes CMP-Verfahren (Chemical Mechanical Polishing) poliert werden. Anschließend wird die inselartige Verbindung von Gates benachbarter Speicherzellen über eine Wortleitung, beispielsweise eine Polysilizium-Wortleitung, hergestellt, in dem die einzelnen Polysilizium-Inseln an den erforderlichen Stellen abgeschieden und - über eine zusätzliche Fotoebene - strukturiert werden.

Zusammenfassend weisen die erfindungsgemäße DRAM-Speicherzelle und der erfindungsgemäße DRAM-Speicher sowie die daraus resultierende neue Speicherzellen- und Bitleitungs-Architektur eine Reihe von Vorteilen auf. Zu nennen ist hier beispielsweise zunächst das mit der Zellenlängsausdehnung linear skalierende Schreib-Leseverstärker-Raster. Damit wird gleichzeitig auch das Bitleitungsraster vergrößert. Dies führt zu einer Verringerung der nachteiligen Koppelkapazitäten zwischen benachbarten Bitleitungen, die um so größer sind, je geringer der Abstand benachbarter Bitleitungen zueinander ist. Um den Widerstand der Wortleitungen gering zu halten, wird die die einzelnen Gates inselartig verbindende Wortleitung, beispielsweise die Polysiliziumleitung, in bestimmten Abständen von einer Metall-Wortleitung kontaktiert. Im Bereich dieser Kontakte muß der Abstand zwischen den Bitleitungen entsprechend vergrößert werden. In der erfindungsgemäß resultierenden Bitleitungs-Architektur können diese Kontakte ohne zusätzlichen Platzaufwand ausgeführt werden. Die Frequenz der Kontaktierung ist dabei wesentlich größer als in konventionellen Bitleitungs-Architekturen. Der Wortleitungswiderstand wird somit verringert.

Die Erfindung wird nun an Hand von Ausführungsbeispielen unter Bezugnahme auf die beiliegende Zeichnung näher erläutert. Es zeigen:

Figur 1 ein Prinzip-Layout einer DRAM-Speicherzelle mit konventioneller Wortleitungs-/Bitleitungs-Orientierung;
Figur 2 in schematischer Ansicht den minimalen Platzbedarf einer DRAM-Speicherzelle mit zwei Wortleitungen für die Wortleitungs- und Bitleitungsverdrahtung;
Figur 3 in schematischer Ansicht den minimalen Platzbedarf für eine DRAM-Speicherzelle für die Wortleitungs- und Bitleitungsverdrahtung bei Verwendung von nur einer Wortleitung;
Figur 4 in schematischer Ansicht eine bekannte "folded" Bitleitungs-Architektur;
Figur 5 in schematischer Ansicht eine bekannte "open" Bitleitungs-Architektur;
Figur 6 in schematischer Ansicht ein Ausführungsbeispiel eines in Teilen dargestellten erfindungsgemäßen DRAM-Speichers;
Figur 7 eine vorteilhafte Layout-Variante für einen erfindungsgemäßen DRAM-Speicher mit 6 $F^2$ Speicherzellen; und
Figur 8 eine andere Layout-Variante für einen erfindungsgemäßen DRAM-Speicher mit 6 $F^2$ Speicherzellen.

In Figur 1 ist in schematischer Weise der Aufbau einer DRAM-Speicherzelle 10 dargestellt. Im vorliegenden Ausführungsbeispiel handelt es sich hierbei um eine sogenannte Doppel-Trench-Zelle. Die DRAM-Speicherzelle 10 weist zwei gleichartig ausgebildete Zellenbestandteile auf.

Die DRAM-Speicherzelle 10 weist zwei Speicherkondensatoren 11 auf, die im vorliegenden Fall als sogenannte Deep-Trench-Kondensatoren ausgebildet sind. Weiterhin sind insgesamt zwei Auswahltransistoren 12 vorgesehen, die jeweils über entsprechende Gates 13 sowie Source-Drain-Gebiete 14 verfügen. Da es sich im vorliegenden Fall um eine Doppel-Trench-Zelle handelt, wird dasjenige Source-Drain-Gebiet 14, das mit einer Bitleitung 15 kontaktiert ist, von beiden Zellenteilen gemeinsam genutzt.

Die einzelenen Bestandteile der Speicherzelle 10 sind im Bereich einer zumindest im wesentlichen rechtekkigen Zellfläche 20 ausgebildet, wobei die Zellfläche 20 eine größere Ausdehnung in Längsrichtung L als in Breitenrichtung B aufweist. Die einzelnen Bestandteile der Speicherzelle 10, das heißt der Speicherkondensator 11 sowie der Auswahltransistor 12, weisen eine minimale Strukturbreite von 1 F auf, wobei F für die minimale lithographische Strukturgröße steht. Weiterhin weist jede Speicherzelle 10 einen Abstand von 1 F zu den jeweils benachbarten Zellen auf, so daß sich im vorliegenden Ausführungsbeispiel eine Zellenbreite 22 von insgesamt 2 F ergibt. Auf ähnliche Weise wird die Zellenlänge 21 bestimmt, so daß sich diese im vorliegenden Fall zu 4 F ergibt. Die Zellfläche 20 des Zellenteils der Speicherzelle 10 ergibt sich somit zu 8 $F^2$.

Jeder Zelenteil der Speicherzelle 10 ist über eine Wortleitung 16, 17 sowie eine Bitleitung 15 mit der Zellperipherie 18 verdrahtet beziehungsweise verdrahtbar. Dabei sind die Wortleitungen 16, 17 sowie die Bitleitung 15 über die Speicherzelle 10 geführt und zumindest im wesentlichen senkrecht zueinander orientiert.

Bei der Speicherzelle 10 handelt es sich um einen aus dem Stand der Technik bekannten Typ, bei dem die Bitleitung 15 in Längsrichtung L der Speicherzelle 10, das heißt parallel zur Längsausdehnung 21 der Speicherzelle 10, orientiert ist.

Die in Figur 1 dargestellte Speicherzelle 10 ist in stark vereinfachter Form auch in Figur 2 dargestellt. Mit dem in Figur 2 dargestellten Speicherzellentyp lassen sich DRAM-Speicher 30 mit sogenannter "folded" Bitleitungs-Architektur realisieren. Ein solcher, aus dem Stand der Technik bekannter, DRAM-Speicher 30 mit "folded" Bitleitungs-Architektur ist in Figur 4 dargestellt.

Im "folded" Bitleitungs-Konzept gemäß Figur 4 sind die Bitleitungen (BL) 32 und entsprechende Referenz-Bitleitungen (BBL) 33 jeweils nebeneinander angeordnet. Die Funktionsweise eines solchen DRAM-Speichers 30 ist in der Beschreibungseinleitung ausführlich erläutert worden, so daß an dieser Stelle auf eine erneute Beschreibung verzichtet wird. Ein solches "folded" Konzept erfordert, daß über jede Speicherzelle 10 zwei Wortleitungen (WL) 16, 17 geführt werden, wie dies aus Figur 2 ersichtlich ist. Eine Wortleitung 16 aktiviert die ausgewählte Speicherzelle 10, während sie die Nachbarzellen und damit die Nachbarbitleitungen deaktiviert beläßt. Die zweite Wortleitung 17 passiert lediglich die auszulesende Speicherzelle 10 und aktiviert, wenn ausgewählt, die Nachbarzellen. Die Verdrahtung der DRAM-Speicherzellen 10 mit einer Bitleitung (BL) 15 sowie zwei Wortleitungen (WL1, WL2) 16, 17 benötigt mindestens eine Zellfläche von 8 $F^2$ (wie in Figur 2 dargestellt) und ist deshalb nur für Zellen $\geq 8F^2$ sinnvoll.

Mit zunehmender Miniaturisierung der Strukturen und damit der DRAM-Speicher 30 wird jedoch zunehmend ein Flächenverbrauch unter 8 $F^2$ für die Zellflächen 20 der Speicherzellen 10 gefordert. Die Verdrahtung muß dann so verändert werden, daß sie nicht den Platzbedarf eines Speicherzellenfeldes 31 bestimmt. Erreicht wird dies, indem über jeder Speicherzelle 10 nur eine Wortleitung (WL) 16 geführt wird. Wie in Figur 3 dargestellt, sinkt der minimale Platzbedarf für die Verdrahtung dabei auf 4 $F^2$. Als Konsequenz für die Bitleitungs-Architektur ergibt sich dadurch der Übergang von dem "folded" Konzept (siehe Figur 4) zum "open" Konzept, wie es in Figur 5 dargestellt ist.

Figur 5 zeigt einen aus dem Stand der Technik bekannten DRAM-Speicher 30 mit einem solchen "open" Konzept. Wie bereits erwähnt wurde, kann für Speicherzellen 10 mit einer Zellfläche 20 von < 8 $F^2$ pro Speicherzelle nur eine einzige Wortleitung 16 zugeführt werden. Als Konsequenz hieraus werden die Nachbarzellen immer mitausgelesen und die Nachbar-Bitleitung (BBL) 33 zur auszulesenden Bitleitung (BL) 32 kann nicht als Referenz-Bitleitung verwendet werden, wie dies bei dem "folded" Konzept gemäß Figur 4 möglich war. Statt dessen wird als Referenz-Bitleitung (BBL) 33 eine Bitleitung aus einem benachbarten Speicherzellenfeld 31 verwendet. Dadurch wird das Raster der im DRAM-Speicher 30 ebenfalls vorgesehenen Schreib-Leseverstärker 34 reduziert. Dieses Raster der Schreib-Leseverstärker (SA) 34 verringert sich bei der in Figur 5 dargestellten konventionellen Anordnung der Wortleitungen 16 und Bitleitungen 15 (siehe auch Figur 3) von 8 F auf 4 F, und zwar unabhängig von der tatsächlichen Größe der Speicherzelle 10. Die Auslegung der Schreib-Leseverstärker 34 in dem auf die Hälfte reduzierten Raster ist mit den für die Ausführung von Schreib-Leseverstärkern üblichen planaren Transistoren jedoch sehr problematisch.

Eine Möglichkeit, wie diese Probleme umgangen werden können, ist im Zusammenhang mit den Figuren 6 bis 8 dargestellt.

In Figur 6 ist ein erfindungsgemäßer DRAM-Speicher 50 dargestellt, der eine Anzahl von DRAM-Speicherzellen 51 aufweist. Die einzelnen DRAM-Speicherzellen 51 können (wie im Zusammenhang mit der Speicherzelle 10 in Figur 1 dargestellt) jeweils einen Speicherkondensator 52, der als Deep-Trench-Kondensator ausgebildet sein kann, sowie einen Auswahltransistor aufweisen. Die einzelnen Komponenten sind jeweils im Bereich einer Zellfläche 59 ausgebildet. Jeder Auswahltransistor weist eine Reihe von Gates 53 auf. Im Source-Drain-Gebiet des Auswahltransistors ist ein Kontakt 54 mit einer Bitleitung 55 vorgesehen.

Im Unterschied zu den in den Figuren 1 bis 5 dargestellten Lösungen ist die Bitleitung 55 nunmehr nicht in Längsrichtung L der Speicherzelle (siehe Figur 1) orientiert. Statt dessen ist die Bitleitung 55 senkrecht zur Längsausdehnung der Speicherzelle 51 in Richtung der Breitenausdehnung der Speicherzelle 51 orientiert (siehe zum Vergleich auch die Darstellung in Figur 1). Damit wird ermöglicht, daß das Bitleitungsraster, und damit auch das Schreib-Leseverstärker-Raster, nunmehr eine Funktion der Längsausdehnung der Speicherzelle 51 wird. Als Ergebnis hiervon skaliert das Schreib-Leseverstärker-Raster nunmehr linear mit der Speicherzellenlänge.

Wenn der Abstand zwischen dem Deep-Trench-Kondensator 52 und dem Gate 53 des Auswahltransistors beispielsweise verkürzt wird, wodurch sich auch die Längsausdehnung der Speicherzelle 51 verkürzt, kann das Raster der Schreib-Leseverstärker ebenfalls in gleicher Weise "fließend" verkleinert werden, ohne daß es zu den aus dem Stand der Technik bekannten sprungartigen Verkleinerungen der Raster von 8 F auf 4 F mit den daraus resultierenden Nachteilen und Problemen kommt.

Da die Bitleitungen 55 nunmehr senkrecht zur Längsausdehnung der Speicherzelle 51 über die Speicherzellen 51 geführt werden, weisen die über die Speicherzellen 51 geführten Wortleitungen 56, 57 nunmehr eine Orientierung in Längsrichtung L der Speicherzelle 51, das heißt parallel zur Längsausdehnung der Speicherzelle 51 auf.

Um eine besonders vorteilhafte Anordnung der Wortleitungen 56, 57 senkrecht zu den Bitleitungen 55 zu realisieren, wird gemäß dem Ausführungsbeispiel in Figur 6 vorgeschlagen, daß jeweils einzelne Gates benachbarter Speicherzellen inselartig durch eine Wortleitung 57 miteinander verbunden sind, wobei diese Wortleitung 57 im vorliegenden Fall als Polysiliziumleitung ausgebildet ist. Diejenigen Gates der Auswahltransistoren, die mit der Polysilizium-Wortleitung 57 verbunden sind, sind im Ausführungsbeispiel gemäß Figur 6 durch die Bezugsziffer 60 bezeichnet. Der besseren Übersicht halber ist die Polysilizium-Wortleitung 57 als "Doppelstrich" dargestellt.

Bei dem Ausführungsbeispiel gemäß Figur 6 sind jeweils vier Gates 60 benachbarter Speicherzellen 51 inselartig durch Polysilizium-Wortleitungen 57 miteinander verbunden. Die einzelnen Polysilizium-Inseln werden wiederum durch eine Metall-Wortleitung 56 miteinander verbunden. Die Wortleitungen 56 sind vorzugsweise direkt über der Polysilizium-Wortleitung 57 angeordnet. Der Verlauf der Metall-Wortleitungen 56 ergibt sich in Figur 6 beispielsweise aus den beiden rechten Reihen von DRAM-Speicherzellen 51. Um den Verlauf der Polysilizium-Wortleitungen 57 besser verdeutlichen zu können, sind die Metall-Wortleitungen 56 bei den beiden linken Reihen von Speicherzellen 51 versetzt dargestellt. Durch den kleinen Pfeil im Kopf der Zeichnung wird jedoch verdeutlicht, daß diese versetzt dargestellten Metall-Wortleitungen 56 eigentlich direkt über den Polysilizium-Wortleitungen 57 verlaufen.

Die Polysilizium-Wortleitungen 57 sind in bestimmten Abständen über entsprechende Kontakte 58 mit der Metall-Wortleitung 56 verbunden.

Um zu gewährleisten, daß auf jede Bitleitung 55 nur eine Speicherzelle 51 ausgelesen wird, kontaktieren zwei nebeneinander laufende Metall-Wortleitungen 56 wechselseitig jeweils auf Inseln 60 verschiedenen Typs. Zur Realisierung der Inseln 60 müssen die Polysiliziumbahnen 57 über das Source-Drain-Gebiet verlaufen, welches den Deep-Trench-Speicherkondensator 52 mit dem Auswahltransistor verbindet. Die hierfür notwendige Isolation kann durch einen abgewandelten "Raised STI"-Prozeß realisiert werden, bei dem jedoch eine zusätzliche Fotoebene nötig ist.

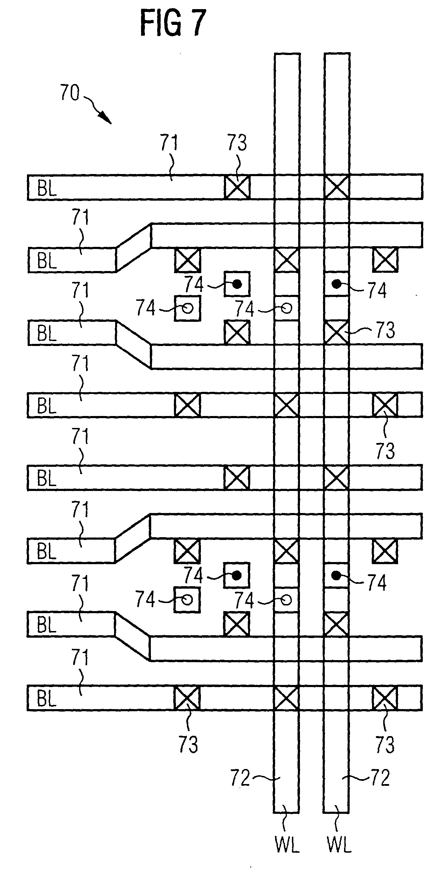

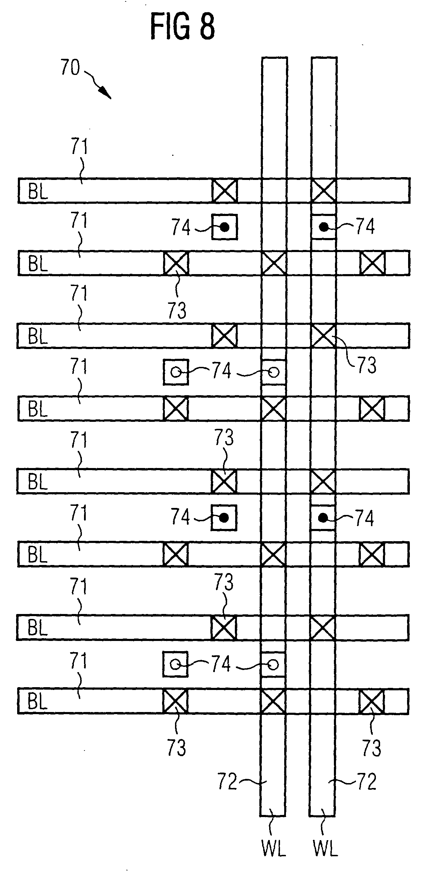

In den Figuren 7 und 8 sind schließlich zwei Ausführungsbeispiele für ein DRAM-Speicher-Layout 70 dargestellt, die eine entsprechend optimierte Architektur der Bitleitungen 71 aufweisen. Beide DRAM-Speicher 70 weisen eine Anzahl von Speicherzellen auf, die als 6 F$^2$ Speicherzellen ausgebildet sind. Die Kontakte 73 zwischen den Bitleitungen 71 und den DRAM-Speicherzellen sind durch gekreuzte Kästchen dargestellt. Die Kontakte 74 zwischen der Metall-Wortleitung 72 und den jeweiligen Polyinseln sind als Quadrate mit einem Kreis dargestellt.

Bei dem in Figur 7 dargestellten Layout-Beispiel sind die Bitleitungen 71 so verlegt, daß mindestens jeweils ein Anstand zwischen den einzelnen Elementen von 1 F eingehalten wird. Das hat zur Folge, daß einige der Bitleitungen 71 Versetzungen aufweisen. Wird der Abstand zwischen den Bitleitungen 71 und den Kontakten 74 auf ½ F reduziert, wie dies in Figur 8 dargestellt ist, können die Bitleitungen 71 mit identischem Raster gerade über das Speicherzellenfeld des DRAM-Speichers verlegt werden.

**Patentansprüche**

1. Integrierte DRAM-Speicherzelle, mit einem Speicherkondensator (11; 52) und einem Auswahltransistor (12), die im Bereich einer zumindest im wesentlichen rechteckigen Zellfläche (20; 59) ausgebildet sind, wobei die Zellfläche (20; 59) eine größere Ausdehnung in Längsrichtung (L) als in Breitenrichtung (B) aufweist, und die über eine Wortleitung (16, 17; 56, 57) und eine Bitleitung (15; 55) mit der Zellperipherie (18) verdrahtet oder verdrahtbar ist, wobei die Wortleitung (16, 17; 56, 57) und die Bitleitung (15; 55) über die Speicherzelle (10; 51) geführt und zumindest im wesentlichen senkrecht zueinander orientiert sind, **dadurch gekennzeichnet,**

**daß** die Bitleitung (15; 55) senkrecht zur Längsausdehnung (21) der Speicherzelle (10; 51) in Richtung der Breitenausdehnung (22) der Speicherzelle (10; 51) orientiert ist.

2. DRAM-Speicher nach Anspruch 1,
**dadurch gekennzeichnet,**
**daß** diese eine Zellfläche (20; 59) von < 8 F$^2$ aufweist.

3. DRAM-Speicherzelle nach Anspruch 1 oder 2,
**dadurch gekennzeichnet,**
**daß** die Bitleitung (15; 55) und/oder die Wortleitung(en) (16, 17; 56, 57) eine Breite von 1 F aufweist/aufweisen.

4. DRAM-Speicherzelle nach einem der Ansprüche 1 bis 3,
**dadurch gekennzeichnet,**
**daß** diese eine Zellbreite (22) von 2 F aufweist.

5. DRAM-Speicherzelle nach einem der Ansprüche 1 bis 4,
**dadurch gekennzeichnet,**
**daß** diese eine Zellenlänge (21) von < 4 F aufweist.

6. DRAM-Speicher, mit einer Anzahl von Speicherzellen (10; 51) nach einem der Ansprüche 1 bis 5, die jeweils ein oder mehrere Speicherzellenfelder (31) bilden, wobei jeweils mehrere Speicherzellen (10; 51) eines Speicherzellenfeldes (31) mit einer Wortleitung (16, 17; 56, 57) und einer Bitleitung (32, 33; 55) verbunden sind, wobei die Wortleitungen (16, 17; 56, 57) ein Wortleitungsraster und die Bitleitungen (32, 33; 55) ein Bitleitungsraster bilden.

7. DRAM-Speicher nach Anspruch 6,
**dadurch gekennzeichnet,**
**daß** diese eine "open" Struktur aufweist.

8. DRAM-Speicher nach Anspruch 7,
**dadurch gekennzeichnet,**
**daß** als Referenz-Bitleitung (33) für die Bitleitung (32; 55) einer Speicherzelle (10; 51) eine Bitleitung (33; 55) aus einem anderen Speicherzellenfeld (31) verwendet wird.

9. DRAM-Speicher nach einem der Ansprüche 6 bis 8,
**dadurch gekennzeichnet,**
**daß** das Bitleitungsraster als Funktion der Längsausdehnung (21) der Speicherzellen (10; 51) gebildet ist.

10. DRAM-Speicher nach einem der Ansprüche 6 bis 9,
**dadurch gekennzeichnet,**
**daß** dieser einen oder mehrere Schreib-Leseverstärker (34) aufweist, der/die zur Auswertung und Weiterverarbeitung der über die Bitleitung (32, 33; 55) übertragenen Signale mit diesen verdrahtet ist/sind.

11. DRAM-Speicher nach Anspruch 10,
**dadurch gekennzeichnet,**
**daß** die Schreib-Leseverstärker (34) in einem zum Bitleitungsraster korrespondierenden Raster angeordnet sind, so daß das Raster der Schreib-Leseverstärker (34) linear mit der Längsausdehnung (21) der Speicherzellen (10; 51) skaliert.

12. DRAM-Speicher nach einem der Ansprüche 6 bis 11,
**dadurch gekennzeichnet,**
**daß** jeweils mehrere Gates (60), insbesondere vier Gates, benachbarter Speicherzellen (10; 51) inselartig über eine Wortleitung (57) miteinander verbunden sind.

13. DRAM-Speicher nach Anspruch 12,
**dadurch gekennzeichnet,**
**daß** die Wortleitung (57) als Polysiliziumleitung ausgebildet ist.

14. DRAM-Speicher nach Anspruch 12 oder 13,

**dadurch gekennzeichnet,**
**daß** die Wortleitung (57) in bestimmten Abständen mit einer Metall-Wortleitung (56) verbunden ist.

15. DRAM-Speicher nach Anspruch 14,
**dadurch gekennzeichnet,**
**daß** die Wortleitungen (56, 57) übereinander angeordnet sind.

16. DRAM-Speicher nach Anspruch 14 oder 15,
**dadurch gekennzeichnet,**
**daß** zwei nebeneinander laufende Metall-Wortleitungen (56) wechselseitig jeweils Speicherzellen-Gates (60) verschiedenen Typs kontaktieren.

17. DRAM-Speicher nach einem der Ansprüche 12 bis 16,
**dadurch gekennzeichnet,**
**daß** die, benachbarte Speicherzellen (10; 51) inselartig verbindende, Wortleitung (57) über das Source-Drain-Gebiet der Speicherzelle(n) (10; 51) geführt ist, das den Speicherkondensator (11; 52) mit dem Auswahltransistor (12) verbindet.

## FIG 1

Sorce/Drain mit BL-Kontakt
Gate
Sorce/Drain
Deep Trench

## FIG 2

## FIG 3

# FIG 4

30

34 — | | — 34

BBL
BL
32
33

— 31

34 — | SA | SA | — 34

BBL
33
BL
32

— 31

8F                8F

34 — | | | — 34

32
33

1F

1F

— 31

34 — | | — 34

# FIG 5

30

33          33

BBL

— 31

| SA | SA | SA | SA | — 34

32

32

BL

1F

— 31

34 — | | | | |

4F          4F

— 31

BBL

EP 1 132 966 A2

FIG 6

50

2F

56

56

56

B

58
51

59

L

51

54

53

55

57

57

59

4.0 F für 8 F$^2$ Zelle
3.5 F für 7 F$^2$ Zelle
3.0 F für 6 F$^2$ Zelle

57

51

54

55

60

58

58

52

60

51

53

60

57

52

57

60

51

53
54

53
60

58

58
52

58

57

60

52

54

59

59

52

55
56 — Metall-BL
57 — Metall-WL
— Poly-WL
[•] Poly-Metall-WL
[o] Kontakte
54 — [⊠] BL-Kontakt
53 — [▨] Poly-Gate
52 — [□] Deep-Trench

# FIG 7

# FIG 8